Europäisches Patentamt

European Patent Office

Office européen des brevets

(19)

(11) Publication number: **0 173 524**
A2

(12) # EUROPEAN PATENT APPLICATION

(21) Application number: 85305855.0

(22) Date of filing: 16.08.85

(51) Int. Cl.⁴: **H 01 L 21/90,** H 01 L 23/56

(30) Priority: 20.08.84 US 642312

(43) Date of publication of application: 05.03.86
Bulletin 86/10

(84) Designated Contracting States: **DE FR GB NL SE**

(71) Applicant: **GOULD INC., 10 Gould Center, Rolling
Meadows, IL 60008 (US)**

(72) Inventor: **Lajos, Robert, 721 Darlington, Crystal Lake
II. 60014 (US)**
Inventor: **Tanielian, Minas, 1326 E. Algonquin,
Schaumburg, II. 60195 (US)**
Inventor: **Blackstone, Scott, 300 E. Evergreen, Mt.
Prospect, II. (US)**

(74) Representative: **Barrett, James William et al, A.A.
THORNTON & CO. Northumberland House 303-306 High
Holborn, London WC1V 7LE (GB)**

(54) Method of eliminating titanium silicide penetration into polysilicon during the oxidation of a polycide structure.

(57) A novel method is described for use in IC technology for reducing the resistance of polysilicon interconnect lines. This is accomplished by placing a refractory metal silicide on the polysilicon interconnect material. In the preferred embodiment of this method, a layer of silicon is interposed between the polysilicon interconnect material and and a titanium silicide to eliminate penetration of the refractory metal silicide into the underlying polysilicon layer during the oxidation process of said structure both in dry and wet oxygen environments.

0173524

D-1398

## BACKGROUND OF THE INVENTION

The invention relates generally to integrated circuit (IC) interconnect technology and more specifically to polycide structures.

An integrated circuit consists of many active and passive components which must be connected together in order to perform a particular circuit function. At present polycrystalline silicon is one of the principle materials used in interconnect technology. As the size of intergrated circuits increases with a corresponding decrease in feature size, the use of polysilicon interconnects places a limitation on the speed of the circuit due to the high resistivity of the polysilicon. Attempts at replacing polycrystalline silicon with alternative materials of lower resistivity result in significant changes in the IC fabrication process. It has been shown that placing a refractory metal silicide directly on top of the polycrystalline silicon to form a composite layer reduces the resistivity of the interconnects and is compatible with the existing IC technology.

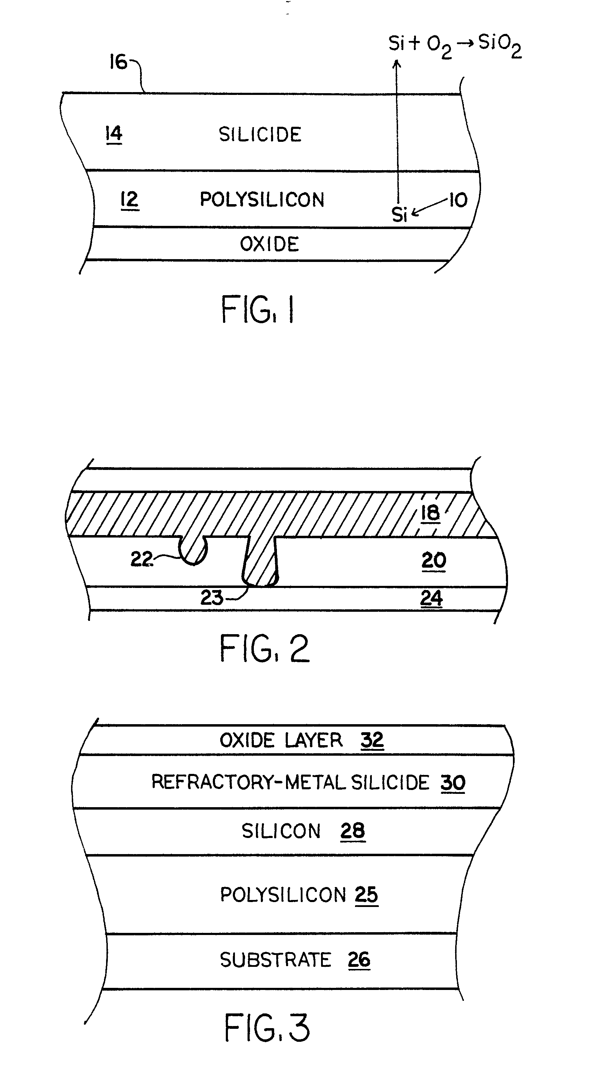

One aspect of compatibility with existing IC technology is the ability to grow an oxide on top of the composite refractory metal silicide/polysilicon structure. It is known that the reliability of the underlying gate oxide can be compromised during the oxidation of these refractory metal silicide/polysilicon structures. The process of oxidation is fairly well documented in the literature (see, for instance, S.P. Murarka, "Silicides for VLSI Applications," AP, N.Y. 1983). Referring now to FIG. 1, the oxidation

0173524
D-1398

process of the polycide structure takes place by the diffusion of Si atoms 10 from the underlying polysilicon layer 12 through the silicide 14 to the top surface 16 and reacting with the oxygen in the atmosphere to form silicon dioxide. The oxidation can be done both in dry and wet $O_2$ containing environments.

It has been recognized that when a tungsten silicide/polysilicon structure is oxidized, voids are formed in the underlying polysilicon layer. This problem has been successfully dealt with in the past by first annealling the structure prior to oxidation. When the inventors of the present invention oxidized a similar structure of titanium silicide/polysilicon it was found that the titanium silicide 18 penetrated the polysilicon layer 20 in a nonuniform manner which formed pits in the polysilicon layer 22 filled with titanium silicide as illustrated in FIG. 2. Annealling techniques similar to the techniques described above with respect to tungsten silicide structures did not remedy the problem.

This pitting is highly undesirable because it was found by the inventors that when the titanium silicide comes in direct contact 23 with the oxide layer 24 underneath the polysilicon layer 20, it degrades the dielectric field strength and thus the reliability of the oxide layer. In a MOS transistor, this underlying oxide, called the gate oxide, is an important component of the transistor structure, and degrading the reliability of this gate oxide degrades the reliability of the entire transistor.

- 3 -

## SUMMARY OF THE INVENTION

The subject invention is a method for forming a refractory-metal silicide/polycide structure on a substrate. A polycide is a composite structure of a polysilicon layer on the substrate with a refractory-metal silicide layer in juxtaposition and on top of the polysilicon layer. The method includes the steps of forming a polysilicon layer, forming a silicon layer on the polysilicon layer, and forming a refractory-metal silicide layer on the silicon layer in which the silicide formation and the silicon layer formation are both formed in-situ. In the preferred embodiment, the refractory-metal silicide is titanium silicide.

An object of the subject invention is to provide a refractory-metal silicide/polycide structure which can be oxidized without inducing nonuniform consumption of the underlying silicon.

Another object of the subject invention is to provide a refractory-metal silicide/polycide structure which does not degrade the field strength of an underlying insulator.

Another object of the subject invention is to provide a refractory-metal silicide/polycide structure which can be oxidized wherein the polysilicon layer thickness can be minimized to improve step coverage of the polycide by subsequent thin films.

These and other objects and advantages of the invention, as well as the details of an illustrated embodiment, will be more fully understood from the following description.

BRIEF DESCRIPTION OF THE DRAWINGS

FIG. 1 illustrates the oxidation mechanics of a refractory-metal silicide/polycide structure;

FIG. 2 illustrates the nonuniform penetration of titanium silicide into the underlying polysilicon during oxidation;

FIG. 3 illustrates one embodiment of the subject invention; and

FIG. 4 illustrates the relative field strength of gate oxides as a function of the thickness of the underlying polysilicon layer with and without using the methods described in the subject invention.

DETAILED DESCRIPTION

The polysilicon layer 25, FIG. 3, was deposited onto the substrate 26 via low pressure chemical vapor deposition, LPCVD, techniques. The polysilicon layer was then doped N+ by phosphorous oxichloride ($POCl_3$) diffusion doping techniques. $POCl_3$ diffusion doping techniques are well known to those skilled in the art and are described in Physics and Technology of Semiconductor Devices, A.S. Grove, Wiley (1967). A layer 28 of approximately 500 angstroms of silicon is sputtered on top of the polysilicon layer. The subject invention provides that immediately after the silicon layer is formed, the refractory-metal silicide layer 30 is sputter deposited onto the silicon layer 28 in the same system and without breaking vacuum. The resulting structure can then be oxidized to form oxide layer 32.

In the preferred embodiment, it is desirable to perform a brief in-situ annealling prior to oxidation.

Depositing the refractory-metal silicide directly onto the underlying polysilicon layer results in nonuniform consumption of the underlying polysilicon layer. The mechanism by which this occurs is not obvious nor is it entirely understood. We believe that this may be a result of a silicon diffusion barrier layer formation between the polysilicon layer and the subsequent refractory-metal silicide layer as a result of the processing steps which are necessary between the polysilicon deposition and titanium silicide deposition. In the subject technique, the deposited silicon layer on top of the polysilicon layer is not exposed to undesirable contamination prior to the deposition of the refractory-metal silicide. This results in a uniform consumption of silicon from the underlying silicon layer during oxidation of the refractory-metal silicide/polycide structure.

The fact that a uniform consumption of silicon is possible during oxidation using the techniques described in the subject invention indicates that a silicon diffusion barrier layer may not be present. In the preferred embodiment in which titanium silicide is used as the refractory-metal silicide, uniform consumption of the underlying polysilicon is particularly important. This is important due to the fact that when titanium silicide comes in contact with silicon dioxide, it reduces the electric field strength of the silicon dioxide. Silicon dioxide is used to form the gate oxide of a MOS transistor and degrading the field strength of the gate oxide results in degrading the performance of the MOS transistor.

In the past, a relatively thick underlying polysilicon layer has been required due to the problem of nonuniform consumption of silicon to which the subject invention is addressed. This relatively thick layer has been required to prevent the silicide from spiking through the underlying silicon layer and contacting the underlying silicon dioxide layer, since such spiking undesirably reduces the field strength of the oxide. Using traditional techniques in which nonuniform silicon consumption occurs, the thickness of the underlying silicon layer has to be in the range of 3000 to 5000 angstroms. Using the techniques described in the subject invention, this thickness can be reduced to a range of 500 to 1500 angstroms.

There are two distinct advantages to the subject invention over the prior art. The first advantage is that for a fixed polycide thickness, a higher ratio of silicide to polysilicon thicknesses can exist thereby reducing resistivity of the resulting polycide. This is desirable because it will increase the speed of the resulting circuit by reducing the RC time constant. The second advantage is for a fixed polycide resistivity, a thinner polycide structure can be used as a result of a thinner polysilicon layer. This is desirable because it can reduce the step height of the polycide structure and improve coverage of this layer by subsequent layers. It is also desirable in applications where ion implanting through the polycide structure is desirable as in ROM manufacturing.

In the case of tungsten silicide/polycide structures, it is known that oxidation can result in void formation in the underlying polysilicon. This void formation can result in discontinuous silicon films thus degrading the characteristics of a MOS transistor structure. The use of the present invention results in uniform consumption of the underlying silicon layer so that such void formation will not occur as a result of the elimination of the silicon diffusion barrier layer.

It is envisioned that the techniques described above with respect to titanium silicide can also be used with tantalum and molybdenum silicide/polycide structures as well.


## EXAMPLE

In one example, a polysilicon layer is deposited onto the substrate at $620^{\circ}C$ via LPCVD techniques. The polysilicon layer is then doped N+ using standard $POCl_3$ diffusion doping techniques. Following the doping step, the doped polysilicon layer is then chemically cleaned and placed into a sputter deposition system. A 500 angstrom silicon layer is sputtered onto the polysilicon layer. Immediately following the silicon deposition and without breaking vacuum, titanium silicide is sputtered onto the silicon layer from a composite target of $TiSi_{2.2}$ to a thickness of 1500 angstroms. The sputtered deposition was performed by pumping the system to a vacuum of $10^{-7}$ torr and backfilling the system with ultra-high purity argon to a pressure of 3 microns. The silicon target was pre-sputtered for 30 minutes prior to deposition at a power of 1500 watts. The titanium silicide target was pre-sputtered for 30 minutes at a power of 1 kilowatt.

In the preferred oxidation, the titanium silicide/polycide structure was annealed and oxidized at 900°C using a sequence of 5 minutes of nitrogen followed by 30 minutes of dry oxygen.

MOS capacitors were formed using this technique in which the underlying polysilicon layer was varied in thickness from zero to 3000 angstroms in 500 angstroms steps. Additional MOS capacitors were formed by sputtering the titanium silicide directly onto the underlying polysilicon as controls. Two post-deposition treatments were carried out on the capacitors formed; one was a nitrogen anneal at 30 minutes, and the second was a 5 minute anneal at 900°C followed by an oxidation step in dry oxygen for 30 minutes. Both the capacitors formed by this invention and the control capacitors were subjected to these treatments.

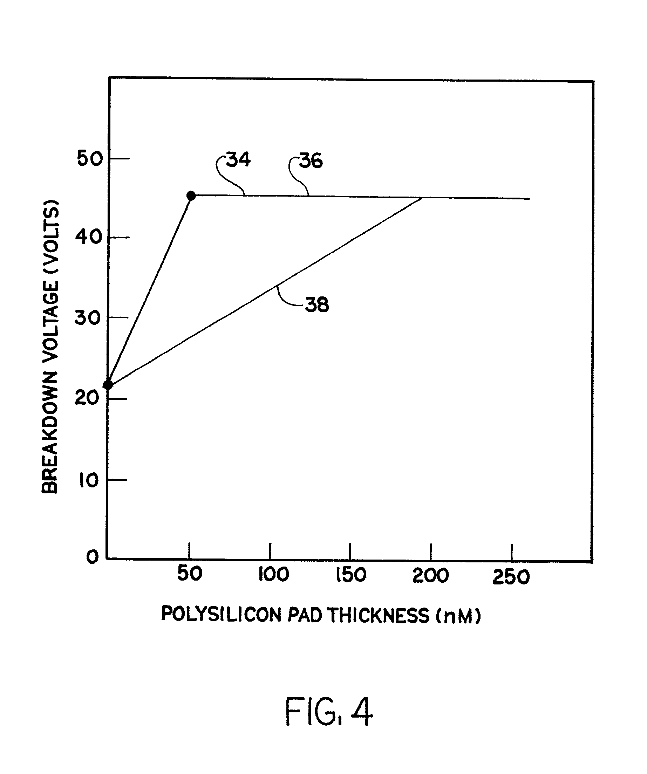

The dielectric field strength of the oxide in the capacitors was measured by ramping a voltage across the capacitors until a current of 1 microamp was measured. The results of these measurements are shown in FIG. 4 which is a plot of the oxide field strength as a function of the underlying polysilicon thickness. In the case of the 30-minute 900°C anneal, the capacitors from both the control and this technique showed similar results and is indicated in 34. In the case of no underlying polysilicon layer, the dielectric field strength is reduced by a factor of 2 due to an interaction between the titanium silicide and the underlying oxide. However, even with a thin 500 angstrom layer of underlying polysilicon, the field strength of the oxide is returned to its original value. Both the capacitors formed with this technique

0173524
D-1398

and the control are similar as a result of the fact that no silicon diffusion from the underlying layer is required during an inert anneal.

For the case of oxidation, the characteristics 36 of the capacitors formed by this technique described by the present invention show no change from the inert ambient annealled capacitors as a result of the uniform silicon consumption from the underlying silicon layer. On the other hand, the control capacitors formed by placing the titanium silicide directly on the underlying polysilicon layer as shown in 38 do not recover the full field strength of the underlying oxide until an underlying polysilicon thickness of approximately 2000 angstroms. This is a result of nonuniform consumption of the underlying silicon layer resulting in the titanium silicide contacting the underlying oxide layer.

Although the invention has been described and illustrated in detail, it is to be clearly understood that the same is by way of illustration and example only, and is not to be taken by way of limitation; the spirit and scope of this invention being limited only by the terms of the appended claims.

WE CLAIM:

1. A method for forming a refractory-metal silicide/polycide structure comprising the steps of:
    forming a polysilicon layer;
    forming a silicon layer on said polysilicon layer; and
    forming a refractory-metal silicide layer on said silicon layer, said silicide layer formation and said silicon layer formation both being formed in-situ.

2. A method as recited in Claim 1 further comprising:
    forming an oxide layer on said refractory-metal silicide.

3. A method as recited in Claim 1 wherein said refractory-metal silicide layer is a titanium silicide layer.

4. A method as recited in Claim 1 wherein said refractory-metal silicide layer is a tungsten silicide layer.

5. A method as recited in Claim 1 wherein said refractory-metal silicide layer is a molybdenum silicide layer.

6. A method as recited in Claim 1 wherein said refractory-metal silicide layer is a tantalum silicide layer.

7. A method as recited in Claim 1 wherein said polysilicon layer is formed by depositing said polysilicon layer on a substrate by LPCVD.

8. A method as recited in Claim 7 wherein said polysilicon layer is doped N+ by POCl3 diffusion.

9. A method as recited in Claim 1 wherein said silicon layer is formed on said polysilicon layer by sputtering.

10. A method as recited in Claim 9 wherein said silicon layer is sputtered to form a layer having a thickness of from 50 to 1000 angstroms.

11. A method as recited in Claim 9 wherein said silicon layer is sputtered to form a layer having a thickness of from 400 to 600 angstroms.

12. A method as recited in Claim 9 wherein said silicon layer is formed by sputtering from an undoped target.

13. A method as recited in Claim 9 wherein said silicon layer is formed by sputtering from a doped target.

14. A method as recited in Claim 1 wherein said silicon layer is formed on said polysilicon layer by LPCVD.

0173524

15. A method as recited in Claim 14 wherein said silicon layer is doped.

16. A method as recited in Claim 9 wherein said refractory-metal silicide layer is formed on said silicon layer by sputtering.

17. A method as recited in Claim 16 wherein said refractory-metal silicide layer is a titanium silicide layer having a thickness of between 500 angstroms to 1 micron.

18. A method as recited in Claim 16 wherein said refractory-metal is a titanium silicide layer having a thickness of 1000 to 2500 angstroms.

19. A method as recited in Claim 14 wherein said refractory-metal layer is a titanium silicide layer formed by LPCVD having a thickness of between 500 angstroms to 1 micron.

20. A method as recited in Claim 14 wherein said refractory-metal layer is a titanium silicide layer formed by LPCVD having a thickness of between 1000 to 2500 angstroms.

21. A MOS structure comprising:
a silicon substrate;
a silicon dioxide layer on said silicon substrate;
a polysilicon layer on said silicon dioxide layer;

a silicon layer on said polysilicon layer;

a refractory-metal silicide layer on said silicon layer; and

an oxidation layer on said refractory-metal.

22. A MOS structure as recited in Claim 21 wherein said refractory-metal silicide layer is a titanium silicide layer

23. A MOS structure as recited in Claim 22 wherein said silicon substrate further includes doped source and drain regions in proximity with and extending from said silicon dioxide layer such that said silicon dioxide layer forms a gate so that said structure is a MOS transistor wherein the gate oxide structure has an electric field strength of 8 to 10 MV/cm.

0173524

Si + O₂ → SiO₂

| | |
|---|---|
| **14** | SILICIDE |
| **12** | POLYSILICON |
| | OXIDE |

$$Si + O_2 \rightarrow SiO_2$$

FIG. 1

**18**

22 **20**

23 **24**

FIG. 2

| |
|---|
| OXIDE LAYER **32** |
| REFRACTORY-METAL SILICIDE **30** |
| SILICON **28** |
| POLYSILICON **25** |
| SUBSTRATE **26** |

FIG. 3

FIG. 4